# EUROPÄISCHE PATENTANMELDUNG

(11) **EP 3 832 517 A1**
(43) Veröffentlichungstag der Anmeldung: **09.06.2021**
(21) Anmeldenummer: 19212861.9
(22) Anmeldetag: 02.12.2019
(51) Int. Cl.: G06F 30/20

(54) **COMPUTERIMPLEMENTIERTES VERFAHREN ZUR EINBINDUNG MINDESTENS EINES SIGNALWERTS IN EINEM VIRTUELLEN STEUERGERÄT**

(71) Anmelder: dspace digital signal processing and control engineering GmbH, 33102 Paderborn (DE)
(72) Erfinder: Süvern, Markus, 33102 Paderborn (DE)

(57) **Zusammenfassung**

Die Erfindung betrifft ein computerimplementiertes Verfahren zur Einbindung mindestens eines Signalwerts in ein virtuelles Steuergerät aufweisend eine Anwendungsschicht, eine Laufzeitumgebung (RTE), eine Basissoftware-Schicht und eine Mikrocontroller-Abstraktions-Schicht. Das virtuelle Steuergerät wird auf einer Simulationsplattform mittels eines Personal Computers ausgeführt wird und benötigt mindestens ein Eingabesignal, wobei dem Eingabesignal mindestens ein Signalwert zugeordnet werden kann. Von einer Simulationsfunktion wird mindestens ein erster simulierter Signalwert dem virtuellen Steuergerät bereitgestellt wird. Die Mikrocontroller-Abstraktions-Schicht weist eine Softwarekomponente zur Einbindung des ersten simulierten Signalwerts und eines zweiten externen Signalwerts in einem virtuellen Steuergerät auf, wobei der zweite externe Signalwert von einem externen Peripheriegerät bereitgestellt wird. Ein Benutzer trifft über eine Benutzerschnittstelle für das Eingabesignal eine Auswahl, ob die Softwarekomponente den ersten simulierten Signalwert oder den zweiten externen Signalwert nutzen soll. In einem weiteren Verfahrensschritt wird bei der Ausführung des virtuellen Steuergeräts entsprechend der Auswahl des Benutzers entweder der erste simulierte Signalwert oder der zweite externe Signalwert dem virtuellen Steuergerät als Signalwert des Eingabesignals zur Verfügung gestellt wird.

## Beschreibung

Des Weiteren betrifft die Erfindung ein virtuelles Steuergerät.

Unter nicht-virtuellen Steuergeräten, also so genannten realen Steuergeräten, werden heutzutage zumeist Kleinrechner mit einer Eingabe/Ausgabe-Schnittstelle verstanden, die oft mit einem echtzeitfähigen Betriebssystem ausgestattet sind, das die Realisierung - auch komplexer - zumeist regelungstechnischer Aufgaben auf dem Steuergerät gestattet. Die Steuergeräte-Entwicklung ist zentraler Bestandteil der technischen Entwicklung von umfangreichen gerätetechnischen Anlagen, wie sie aus der industriellen Praxis bekannt sind. Beispielhaft zu nennen ist der Einsatz von Steuergeräten im automotiven Bereich und in der Luft- und Raumfahrt.

Der Test des im Endprodukt zum Einsatz kommenden Serien-Steuergeräts ist der Endpunkt einer Mehrzahl vorgelagerter Entwicklungsschritte einer auf dem Steuergerät zu implementierenden Regelung oder Steuerung, wobei diese Entwicklungsschritte üblicherweise mit dem sogenannten V-Modell oder auch V-Zyklus beschrieben werden. Am Anfang der für die Funktion vieler technischer Anlagen essentiellen Reglerentwicklung steht die mathematische Modellierung des Regelungsalgorithmus auf einem Rechner mit einer mathematisch-graphischen Modellierungsumgebung, wobei der Regler als Bestandteil des Steuergeräts aufzufassen ist. Zusätzlich wird auch die Umgebung des Steuergeräts mathematisch modelliert, da die Interaktion des Reglers auf dem Steuergerät mit dem zu steuernden Prozess von Interesse ist. Bei diesen funktionalen mathematischen Betrachtungen ist eine Simulation in Echtzeit meist nicht erforderlich (Offline-Simulation).

Im nächsten Schritt wird der zuvor entworfene Regelungsalgorithmus mit Hilfe des Rapid-Control-Prototyping auf eine leistungsfähige, meist echtzeitfähige Hardware übertragen, die über geeigneten Eingabe/Ausgabe-Schnittstellen mit dem tatsächlichen physikalischen Prozess verbunden ist, also beispielsweise mit einem Kraftfahrzeug-Motor. Diese echtzeitfähige Hardware hat mit dem später zum Einsatz kommenden Serien-Steuergerät im Regelfall nichts zu tun, es geht hier um den Nachweis der prinzipiellen Funktionsfähigkeit der zuvor entworfenen Regelung in der Praxis.

In einem weiteren Schritt wird im Rahmen der automatischen Seriencodegenerierung die Regelung auf dem später im Serien-Steuergerät wahrscheinlich tatsächlich zum Einsatz kommenden Zielprozessor implementiert. Die Zielhardware nähert sich demnach in diesem Schritt dem Serien-Steuergerät an, ist mit dem Serien-Steuergerät aber nicht identisch. In einem weiteren Schritt wird das üblicherweise erst in einem späten Entwicklungsstadium vorhandene Serien-Steuergerät im Rahmen eines Hardware-in-the-Loop-Tests (HIL-Test) überprüft. Das in diesem Schritt physikalisch vorhandene Serien-Steuergerät wird hier mittels seiner physikalischen Steuergeräteschnittstelle mit einem leistungsfähigen Simulator verbunden. Der Simulator simuliert die benötigten Größen des zu testenden Serien-Steuergeräts und tauscht Ein- und Ausgangsgrößen mit dem Serien-Steuergerät aus. Die Pins der physikalischen Steuergeräte-Schnittstelle des Serien-Steuergeräts sind über einen Kabelbaum mit dem Simulator verbunden. So ist es möglich, in der Simulationsumgebung alle benötigten Größen eines Kraftfahrzeug-Motors - gegebenenfalls das gesamte Kraftfahrzeug mit Motor, Antriebstrang, Fahrwerk und Fahrstrecke - zu simulieren und das Verhalten des Serien-Steuergeräts im Zusammenspiel mit der Simulationsumgebung gefahrlos zu überprüfen.

Der HIL-Simulator emuliert die elektrischen Signale von Sensoren und Aktoren, die vom Steuergerät gelesen werden. Das Steuergerät wiederum generiert auf Basis der eingegangenen Signale mittels der Steuerungssoftware Sensor- und/oder Aktorsteuersignale, die wiederum zu einer Änderung der elektrischen Signale im HIL - Simulator führen. Die vom HIL -Simulator emulierten elektrischen Signale werden mittels eines Umgebungsmodells erzeugt, welches die benötigten Signale abbildet, also die gesamte Umgebung. Das Umgebungsmodell beinhaltet neben der eigentlichen Regelstrecke noch zusätzlich so genannte Störmodelle, die auf den Regelkreis einwirken, also z.B. wechselnde Umgebungsbedingungen wie Temperatur, Gegenwind, Fahrbahnunebenheit, Sensorsignalfehler wie elektrische Störungen und Lenkbewegungen des Fahrer-(modells). Die Strecke, die im realen Fahrversuch als Versuchsstrecke abgefahren und so unterschiedliche elektrische Signale für das Steuergerät generieren würde, wird innerhalb der HIL -Simulation somit im Umgebungsmodell abgebildet. Um einen HIL -Test durchzuführen, muss allerdings die Entwicklung eines Steuergerätes schon relativ weit fortgeschritten sein, da das Steuergerät über seine Hardware an den HIL -Simulator angeschlossen wird.

Das so im Rahmen der HIL-Simulation getestete Serien-Steuergerät wird letztendlich in dem "echten" Zielsystem, also beispielsweise in einem Kraftfahrzeug verbaut und in der echten physikalischen Umgebung getestet, die zuvor in der Simulationsumgebung nur vorgetäuscht worden ist.

Der zuvor skizzierte Entwicklungsprozess bei der Reglerentwicklung hat sich außerordentlich bewährt. Dieser Entwicklungsprozess bringt es jedoch mit sich, dass das Serien-Steuergerät erst ganz am Ende der Entwicklung in den Entwicklungsprozess eingebunden wird und damit auch erst in späten Entwicklungsständen überprüft wird. Bevor das Serien-Steuergerät tatsächlich vorliegt, können mit dem aufgezeigten Entwicklungsprozess nur Funktionalitäten auf abstrakter funktioneller Ebene getestet werden, also praktisch nur auf der Ebene der Applikationssoftware. Ein guter Teil der später auf dem Serien-Steuergerät zum Einsatz kommenden Software-Komponenten wird in frühen Entwicklungsständen nicht mitgetestet. Zu diesen Software-Komponenten gehört beispielsweise das Runtime-Environment, das zwischen der Applikationssoftware und den hardwarenahen Softwareschichten vermittelt. Hardwarenähere Softwarekomponenten sind beispielsweise das Betriebssystem und plattform-unabhängige Basissoftware (Systemdienste, Kommunikationsdienste, I/O-Hardware-Abstraktionsschicht usw.) und schließlich plattform-abhängige Teile des Betriebssystems und der Basissoftware.

Um frühere Tests der Steuerungssoftware zu ermöglichen, beispielsweise zu einem Entwicklungszeitpunkt, zu dem noch keine Steuergeräte-Hardware vorliegt, sind Hardware-unabhängige Softwaretests erforderlich. Hierfür haben sich virtuelle Steuergeräte, auch V-ECUs genannt, etabliert (siehe dSPACE Catalog 2019, S. 52-53). Mittels eines virtuellen Steuergerätes wird in einem Simulationsszenario ein echtes Steuergerät emuliert.

Ein virtuelles Steuergerät enthält noch nicht die dafür vorgesehene Steuergeräte-Hardware. Es besteht aus mindestens einem Teil der Steuerungssoftware eines realen Steuergeräts und Softwaremodulen zur Anbindung der Steuerungssoftware an eine Simulationsplattform.

Da das virtuelle Steuergerät noch nicht die dafür vorgesehene Steuergeräte-Hardware enthält, muss es für einen Test der Steuerungssoftware auf einer anderen Hardware bzw. einem Prozessor ausgeführt werden. Dies erfolgt in der Regel auf einem Personal Computer. Ein Personal Computer ist ein Computer für einen einzelnen Arbeitsplatz oder für Privathaushalte. Er tritt beispielsweise als Desktop-, Notebook- oder Tablet-Computer in Erscheinung und kann unter einem beliebigen Betriebssystem laufen, wie beispielsweise Windows, iOS oder Unix.

Um ein virtuelles Steuergerät auf einem Personal Computer ausführen zu können braucht es eine geeignete Simulationsplattform, auf welcher das virtuelle Steuergerät ausgeführt wird. Eine Simulationsplattform ist eine Software, welche die Ausführung eines virtuellen Steuergerätes ermöglicht und zusätzlich eine Möglichkeit bietet, vom virtuellen Steuergerät benötigte Signalwerte dem virtuellen Steuergerät zur Verfügung zu stellen. Mittels der Simulationsplattform kann das virtuelle Steuergerät auf die Hardware des Personal Computers zugreifen.

Ein Beispiel für eine solche Simulationsplattform ist VEOS von dSPACE (siehe dSPACE Catalog 2019, S. 118-123).

Es gibt unterschiedliche Abstufungen, wie viel Steuerungssoftware des virtuellen Steuergeräts bereits der Steuerungssoftware des späteren realen Steuergeräts entspricht. So kann ein virtuelles Steuergerät erstellt werden, dass nur eine oder wenige Komponenten enthält, die auch das spätere reale Steuergerät enthält, bis zur nahezu vollständigen Steuerungssoftware des späteren realen Steuergeräts.

In der Regel ist die Steuerungssoftware eines Steuergeräts in mehreren Schichten aufgebaut. So gibt es in der Regel eine Anwendungsschicht (Application Layer), eine Laufzeitumgebung (Runtime Environment), eine Basissoftware-Schicht (BSW-Layer) und eine Mikrocontroller-Abstraktions-Schicht (Microcontroller Abstraction Layer).

Häufig wird Steuerungssoftware für automotive Steuergeräte nach dem AUTOSAR-Standard aufgebaut. AUTOSAR (AUTomotive Open System ARchitecture) ist eine offene und standardisierte Softwarearchitektur für elektronische Steuergeräte (ECUs), mit dem Ziel, Software in Fahrzeugen unterschiedlicher Hersteller und Elektronikkomponenten verschiedener Anbieter einzusetzen. Das Hauptkonzept der AUTOSAR Softwarearchitektur ist die Trennung von hardwareunabhängiger Anwendungssoftware, also der Anwendungsschicht und hardwareorientierter Basissoftware (BSW) mittels der Laufzeitumgebung (Runtime Environment, kurz RTE). Eine solche Softwarearchitektur ermöglicht durch die Trennung, dass eine komponentenorientierte, hardwareunabhängige Softwarestruktur auf Anwendungsebene ohne spezifische Kenntnisse der verwendeten oder geplanten Hardware entwickelt werden kann.

Die Basissoftware (BSW) innerhalb der AUTOSAR-Softwarearchitektur weist die folgenden Schichten, bezeichnet als Layer, auf: Service-Layer, ECU Abstraction-Layer und Microcontroller Abstraction-Layer (MCAL). Die Basissoftware wird weiterhin in unterschiedliche Basissoftwaremodule unterteilt. Der MCAL ist die unterste Schicht der Basissoftware. Bei realen Steuergeräten, also Steuergeräten mit der dafür vorgesehenen Steuergerätehardware, wird der Zugriff auf den Mikrocontroller des Steuergerätes über den MCAL geleitet. Der MCAL enthält Treiber mit direktem Zugriff auf die internen Peripheriegeräte des realen Steuergeräte-Mikrocontrollers und versorgt die weiteren Komponenten der Basissoftware mit den benötigten Werten. Der MCAL ist ein hardwarespezifischer Layer, der eine Standardschnittstelle zur Basissoftware sicherstellt.

Im virtuellen Steuergerät muss der MCAL ebenfalls eine Standardschnittstelle zur Basissoftware sicherstellen. Da jedoch nicht auf die zur Steuerungssoftware zugehörige Steuergeräte-Hardware zugegriffen werden kann, müssen die Schnittstellen der Basissoftware durch andere Softwarefunktionen mit den benötigten Eingabesignalen bzw. zugehörigen Signalwerten bedient werden und die Ausgabesignale der Steuerungssoftware bzw. die zugehörigen Signalwerte an Schnittstellen mit der Umgebung des virtuellen Steuergeräts weitergeleitet werden können.

Je weiter die Steuerungssoftware eines virtuellen Steuergeräts entwickelt ist, d.h. je näher sie an der letztendlich in das reale Steuergerät einzubauenden Steuerungssoftware ist, um so wichtiger ist es, dass die Schnittstellen der Basissoftware in den benötigten Test möglichst realitätsnahe Signalwerte erhalten.

Um möglichst realitätsnahe virtuelle Steuergeräte zu erstellen und die Software durch reproduzierbare Tests abzusichern, kann ein virtuelles Steuergerät auf Basis der Steuerungssoftware des echten Steuergerätes erstellt werden. Dabei müssen natürlich einige Komponenten der Steuerungssoftware des echten Steuergerätes an die virtuelle Umgebung der Simulationsplattform angepasst werden.

Beispielsweise sind die Mikrocontroller realer Steuergeräte oftmals an externe Peripheriegeräte wie z.B. Funkempfänger, Beschleunigungssensoren, Speicherbausteine, Gyroskope oder aber auch weitere Mikrocontroller über einen SPI-Bus (SPI =Serial Peripheral Interface) angeschlossen. Peripheriegeräte sind eine funktionale Erweiterung des Mikrocontrollers für die Erfassung oder Ausgabe physikalischer und\oder elektrischer Größen. Die Peripheriegeräte sollen bei einer Simulation mit einem virtuellen Steuergerät geeignet mit simuliert werden.

Die Simulation von Peripheriegeräten, insbesondere SPI-Peripheriegeräten, wird insbesondere dann relevant, wenn die Basissoftware des realen Steuergeräts mit getestet werden soll und somit einen Teil des virtuellen Steuergeräts darstellt.

Bei SPI-Peripheriegeräten besteht jedoch das Problem, dass diese teilweise sehr komplex sind und eine Softwarenachbildung für die Simulation sehr aufwendig und somit auch fehleranfällig ist. Bislang wurde auf die Einbindung von Peripheriegeräten bei der Simulation mit virtuellen Steuergeräten weitgehend verzichtet. Stattdessen mussten im Stand der Technik geeignete Freischnitte in der Steuerungssoftware vorgesehen werden, um z.B. Sensordaten aus einem Simulationsmodell in das virtuelle Steuergerät einzuschleusen. Allerdings verändern solche Freischnitte die Steuerungssoftware, so dass nicht die eigentliche Steuerungssoftware getestet werden kann, sondern nur die durch Freischnitte angepasste Steuerungssoftware.

Die Aufgabe der Erfindung ist es, den Stand der Technik weiter zu bilden.

Die Aufgabe wird durch die Merkmale der unabhängigen Patentansprüche gelöst. Bevorzugte Weiterbildungen finden sich in den Unteransprüchen.

Erfindungsgemäß wird ein Verfahren zur Einbindung mindestens eines Signalwerts in ein virtuelles Steuergerät bereitgestellt, wobei das virtuelle Steuergerät eine Anwendungsschicht, eine Laufzeitumgebung, eine Basissoftware-Schicht und eine Mikrocontroller-Abstraktions-Schicht aufweist und das virtuelle Steuergerät auf einer Simulationsplattform mittels eines Personal Computers ausgeführt wird.

Das virtuelle Steuergerät benötigt mindestens ein Eingabesignal. Dem Eingabesignal kann mindestens ein Signalwert zugeordnet werden. Weiterhin wird von einer Simulationsfunktion mindestens ein erster simulierter Signalwert dem virtuellen Steuergerät bereitgestellt. Die Mikrocontroller-Abstraktions-Schicht des virtuellen Steuergeräts weist eine Softwarekomponente zur Einbindung des ersten simulierten Signalwerts und eines zweiten externen Signalwerts in einem virtuellen Steuergerät auf, wobei der zweite externe Signalwert von einem externen Peripheriegerät bereitgestellt wird. Ein Benutzer trifft über eine Benutzerschnittstelle für das Eingabesignal eine Auswahl, ob die Softwarekomponente den ersten simulierten Signalwert oder den zweiten externen Signalwert nutzen soll, wobei in einem weiteren Verfahrensschritt, bei der Ausführung des virtuellen Steuergeräts entsprechend der Auswahl des Benutzers entweder der erste simulierte Signalwert oder der zweite externe Signalwert vom virtuellen Steuergerät als Signalwert des Eingabesignals dem virtuellen Steuergerät als Signalwert des Eingabesignals zur Verfügung gestellt wird.

Wie bereits beschrieben soll getestet werden, ob die Steuerungssoftware eines virtuellen Steuergeräts auf jeden Signalwert eines Eingabesignals korrekt reagiert. Jedes Eingabesignal kann verschiedene Werte, genauer gesagt Signalwerte, annehmen. Dem virtuellen Steuergerät sollen möglichst geeignete Signalwerte für einen Test der Steuerungssoftware bereitgestellt werden. Möglichst geeignete Signalwerte bedeutet in diesem Fall, dass die Signalwerte entweder möglichst identisch mit Signalwerten sind, die ein reales Steuergerät zur Verfügung bekommt oder genau solche Signalwerte sind, mit denen getestet werden kann, ob das virtuelle Steuergerät wie gewünscht auf den Signalwert reagiert. Dafür können auch Werte im Randbereich der möglichen Signalwerte notwendig sein.

Um möglichst realitätsnahe Signalwerte zu erhalten, können diese entweder als externer Signalwert aus dem Peripheriegerät zur Verfügung gestellt werden, welches später an das reale Steuergerät angeschlossen wird oder ein Signalwert wird mittels einer Simulationsfunktion simuliert und ist somit ein simulierter Signalwert.

Eine solche Simulationsfunktion ist eine Softwarefunktion die einen Signalwert, ggf. anhand von einem Eingabeparameter oder mehreren Eingabeparametern, berechnet.

Die Berechnung des Signalwerts in der Simulationsfunktion kann beispielsweise eine feste Signalwertzuordnung, z.B. anhand einer Bedingung oder Tabelle sein oder auch eine Berechnung anhand eines Berechnungsmodells. Sie wird beispielsweise in einer Simulationsumgebung anhand des Umgebungsmodells ausgeführt oder kann direkt in das virtuelle Steuergerät integriert sein.

Da eine Simulation grundsätzlich fehleranfällig ist, ist es wünschenswert, möglichst reale Signalwerte aus einem Peripheriegerät zu verwenden. Vor allem, wenn der externe Signalwert aus einem realen Peripheriegerät erhalten wird, dass später an die reale Steuergerätehardware angeschlossen wird, kann die Steuerungssoftware realitätsnah getestet werden und es können somit Testfehler durch Fehler in der Simulation vermieden werden.

Um zu testen, ob das virtuelle Steuergerät auch im Grenzbereich oder über den Grenzbereich möglicher Signalwerte hinaus korrekt reagiert, muss entweder das Peripheriegerät solche externen Signalwerte liefern können oder diese müssen mittels Simulation als simulierte Signalwerte erzeugbar sein.

Aus dem Stand der Technik ist bekannt von einer Simulationsfunktion mindestens einen ersten simulierten Signalwert dem virtuellen Steuergerät bereit zu stellen. Ein simulierter Signalwert wird beispielsweise durch ein mathematisches Simulationsmodell berechnet. Dies erfolgt in der Regel mittels eines Umgebungsmodells.

Das Umgebungsmodell beinhaltet neben der eigentlichen Regelstrecke noch zusätzlich so genannte Störmodelle, die auf den Regelkreis einwirken, also z.B. wechselnde Umgebungsbedingungen wie Temperatur, Gegenwind, Fahrbahnunebenheit, Sensorsignalfehler wie elektrische Störungen und Lenkbewegungen des Fahrer-(modells). Die Strecke, die im realen Fahrversuch als Versuchsstrecke abgefahren und so unterschiedliche elektrische Signale für das Steuergerät generieren würde, wird somit im Umgebungsmodell abgebildet. Bisher wird ein virtuelles Steuergerät im Computer zur Simulation mit verschiedenen Komponenten, wie virtuellen Sensoren, Aktuatoren und Steuergeräte-Netzwerken verbunden. Die virtuellen Sensoren, Aktuatoren und/oder Steuergeräte-Netzwerke, also die virtuellen Hardware-Komponenten, sind dabei in das Umgebungsmodell als Hardware-Komponenten-Modell integriert. Beispielsweise ist ein virtueller Sensor als Sensormodell in das Umgebungsmodell integriert.

Statt im Umgebungsmodell außerhalb des virtuellen Steuergerätes kann die Simulationsfunktion auch innerhalb des virtuellen Steuergerätes, beispielsweise als virtueller Sensor in der Mikrocontroller-Abstraktions-Schicht implementiert sein.

Erfindungsgemäß wird ein zweiter externer Signalwert dem virtuellen Steuergerät bereitgestellt. Der zweite externer Signalwert wird durch ein externes Peripheriegerät bereitgestellt. Das externe Peripheriegerät erfüllt somit die ihm zugedachte Funktion und gibt über seine Schnittstelle mindestens einen entsprechenden Signalwert aus.

Viele Peripheriegeräte stellen ihre Signalwerte über ein Serial Peripheral Interface, also einen so genannten SPI-BUS einem realen Steuergerät bereit. Ein Personal Computer weist in der Regel eine USB-Schnittstelle (USB = Universal Serial Bus) auf. Mittels eines USB-SPI-Adapters wird das externe Peripheriegerät mit dem Personal Computer verbunden. Mit einem USB-SPI-Adapter kann von einem Personal Computer aus via USB mit einfachsten Befehlen direkt auf angeschlossene Geräte oder Bausteine mit SPI-Schnittstelle zugegriffen werden, bzw. es kann umgekehrt ein Signalwert vom externen Peripheriegerät mit SPI-Schnittstelle im Personal Computer empfangen werden.

In einer bevorzugten Ausführungsform sendet das virtuelle Steuergerät eine Nachricht an das externe Peripheriegerät und das externe Peripheriegerät stellt den zweiten externen Signalwert als Antwort auf die Nachricht bereit.

Eine Nachricht und eine Antwort auf eine Nachricht sind beispielsweise jeweils eine Buskommunikation nach einem standardisierten Datentransferprotokoll.

Erfindungsgemäß ermöglicht eine Softwarekomponente in der Mikrocontroller-Abstraktions-Schicht einem Eingabesignal als Signalwert entweder den ersten simulierten Signalwert oder den zweiten externen Signalwert zuzuweisen.

Ein Benutzer trifft über eine Benutzerschnittstelle für mindestens ein Eingabesignal bzw. jedes Eingabesignal eine Auswahl, ob die Softwarekomponente den ersten simulierten Signalwert oder den zweiten externen Signalwert nutzen soll, wobei in einem weiteren Verfahrensschritt, bei der Ausführung des virtuellen Steuergeräts entsprechend der Auswahl des Benutzers entweder der erste simulierte Signalwert oder der zweite externe Signalwert vom virtuellen Steuergerät als Signalwert des Eingabesignals genutzt wird.

Beispielsweise setzt der Benutzer für jedes Eingabesignal in der Benutzerschnittstelle eine Markierung, ob der externe Signalwert oder der simulierte Signalwert für das Eingabesignal genutzt werden soll.

In einer anderen erfindungsgemäßen Ausführungsform ist entweder für alle Eingabesignale der externe Signalwert oder für alle Eingabesignale der simulierte Signalwert vorausgewählt und der Benutzer trifft die konkrete Auswahl, ob der externe Signalwert oder der simulierte Signalwert genutzt werden soll dadurch, dass er diese Einstellung für mindestens ein konkretes Eingabesignal über die Benutzerschnittstelle ändert.

Ist es beispielsweise vorausgewählt, dass der externe Signalwert für alle Eingabesignale genutzt werden soll, so kann der Benutzer erfindungsgemäß diese Einstellung über eine Benutzerschnittstelle für mindestens ein Eingabesignal ändern und auswählen, dass der Signalwert aus einer Simulationsfunktion genutzt werden soll.

Ein Benutzer ist hierbei jemand, der das virtuelle Steuergerät testen möchte. Eine Benutzerschnittstelle ermöglicht dem Benutzer Einstellungen an dem virtuellen Steuergerät oder einem Test des virtuellen Steuergeräts vorzunehmen. Dies kann über alle bekannten Arten von Benutzerschnittstellen, beispielsweise Konfigurationsmöglichkeiten per Menü, per Maus, über Gesten oder per Sprachsteuerung, erfolgen.

Durch die Erfindung kann das virtuelle Steuergerät so realitätsnah wie möglich getestet werden. So können beispielsweise alle Werte aus dem externen Peripheriegerät für Testfälle mit Signalwerten im Normalbereich genutzt werden, aber Signalwerte im Grenzbereich können durch simulierte Signalwerte dem virtuellen Steuergerät zur Verfügung gestellt werden, so dass getestet werden kann, wie das virtuelle Steuergerät auf diese Signalwerte regiert.

Auch gibt es externe Peripheriegeräte, wie z.B. Speicherbausteine, deren Kommunikation mit dem Steuergerät gut übernommen werden kann, während andere externe Peripheriegeräte, wie z.B. ein Beschleunigungssensor einem virtuellen Steuergerät keine realistischen Werte liefern kann, da er in der Testsituation keine Beschleunigung erfährt, sondern vermutlich konstant in einer Position liegt. Hier ist es in einem Test hilfreich, z.B. die Startkommunikation, die eine Verbindung zwischen dem Beschleunigungssensor und dem virtuellen Steuergerät per sogenanntem Handshake herstellt, mit den realen externen Signalwerten durchzuführen, aber die eigentlichen Beschleunigungswerte dem virtuellen Steuergerät per simulierten Signalwerten zur Verfügung zu stellen.

Die Erfindung betrifft weiterhin ein virtuelles Steuergerät, wobei das virtuelle Steuergerät eine Anwendungsschicht, eine Laufzeitumgebung (RTE), eine Basissoftware-Schicht und eine Mikrocontroller-Abstraktions-Schicht aufweist und auf einer Simulationsplattform mit einem Personal Computer ausführbar ist. Weiterhin benötigt das virtuelle Steuergerät mindestens ein Eingabesignal, wobei dem Eingabesignal mindestens ein Signalwert zugeordnet werden kann. Das erfindungsgemäße virtuelle Steuergerät weist mindestens eine Simulationsschnittstelle auf, um einen ersten simulierten Signalwert von einer Simulationsfunktion zu erhalten. Weiterhin weist das virtuelle Steuergerät mindestens eine Peripheriegeräteschnittstelle zu einem zweiten externen Signalwert auf, wobei der zweite externe Signalwert von mindestens einem externen Peripheriegerät bereitgestellt wird. Die Peripheriegeräteschnittstelle ist hierbei eine Softwareschnittstelle, mittels derer auf eine Hardwareschnittstelle des externen Peripheriegeräts zugegriffen werden kann. Häufig weisen externe Peripheriegeräte eine SPI-Schnittstelle auf, sie können somit über einen SPI-Bus (SPI steht für ein Serial Peripheral Interface) mit anderen Geräten kommunizieren. In einer bevorzugten Ausführungsform ist das externe Peripheriegerät über einen USB-SPI-Adapter an den Personal Computer angeschlossen ist. Die Peripheriegeräteschnittstelle des virtuellen Steuergeräts greift dann beispielsweise über USB auf Signalwerte des externen Peripheriegeräts zu bzw. kann mit dem externen Peripheriegerät über USB kommunizieren.

Die Mikrocontroller-Abstraktions-Schicht des virtuellen Steuergeräts weist eine Softwarekomponente zur Einbindung des ersten simulierten Signalwerts und / oder des zweiten externen Signalwerts in das virtuelle Steuergerät auf. Weiterhin weist das virtuelle Steuergerät eine Benutzerschnittstelle zum Benutzer auf, durch die der Benutzer für jedes Eingabesignal entscheiden kann, ob die Softwarekomponente den ersten simulierten Signalwert oder den zweiten externen Signalwert als Signalwert für das Eingabesignal nutzen soll.

In einer weiteren Ausführungsform ist die Softwarekomponente des virtuellen Steuergeräts derart ausgestaltet ist, dass mittels der Softwarekomponente Nachrichten an das externe Peripheriegerät gesendet werden können.

Im Einzelnen gibt es nun eine Vielzahl von Möglichkeiten, das erfindungsgemäße Verfahren und das erfindungsgemäße virtuelle Steuergerät auszugestalten und weiterzubilden. Dazu wird auf die Patentansprüche 1, 4, 5 und 8 und nachgeordneten Patentansprüche sowie auf die nachfolgende Beschreibung bevorzugter Ausführungsbeispiele der Erfindung unter Bezugnahme auf die Zeichnung verwiesen. In der Zeichnung zeigen
- Fig. 1: ein erstes Ausführungsbeispiel für ein erfindungsgemäßes virtuelles Steuergerät,
- Fig. 2: ein weiteres Ausführungsbeispiel für ein erfindungsgemäßes virtuelles Steuergerät,
- Fig. 3: ein weiteres Ausführungsbeispiel für ein erfindungsgemäßes virtuelles Steuergerät,
- Fig. 4: ein Ausführungsbeispiel für ein erfindungsgemäßes Verfahren

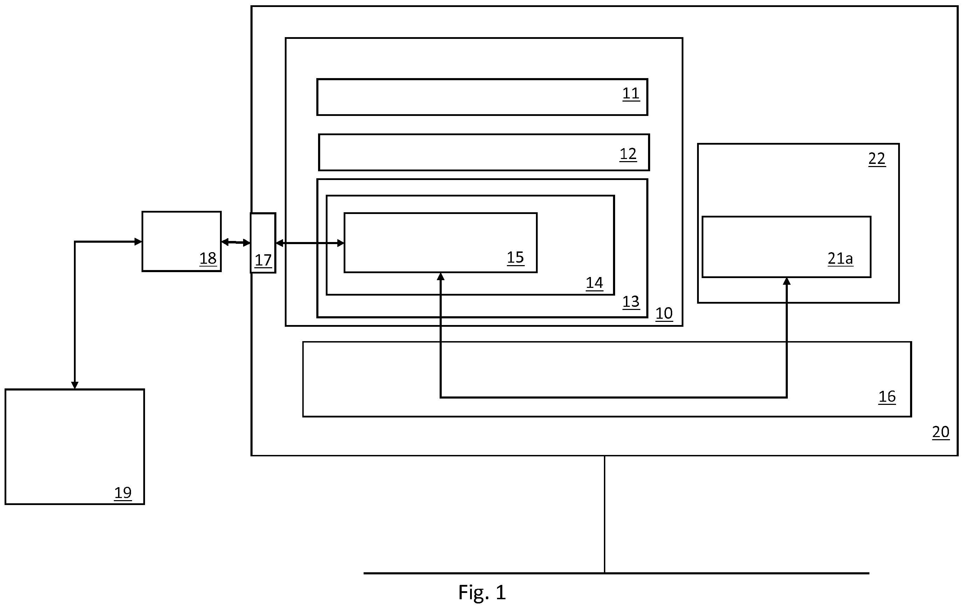

Figur 1 zeigt ein erstes Ausführungsbeispiel für ein erfindungsgemäßes virtuelles Steuergerät 10. Das Steuergerät 10 enthält mehrere Schichten, wie die Anwendungsschicht 11, die Laufzeitumgebung 12 und die Basissoftware-Schicht 13. Die Basissoftware-Schicht 13 enthält wiederum die Mikrocontroller-Abstraktions-Schicht 14. In der Mikrocontroller-Abstraktions-Schicht 14 befindet sich die Softwarekomponente 15, welche Daten aus der Simulationsfunktion 21a erhalten kann. In Figur 1 befindet sich die Simulationsfunktion 21a im Umgebungsmodell 22 und kommuniziert mit der Softwarekomponente 15 über die Simulationsplattform 16, auf der in diesem Beispiel sowohl das virtuelle Steuergerät 10 als auch das Umgebungsmodell 22 mit der Simulationsfunktion 21a ausgeführt werden.

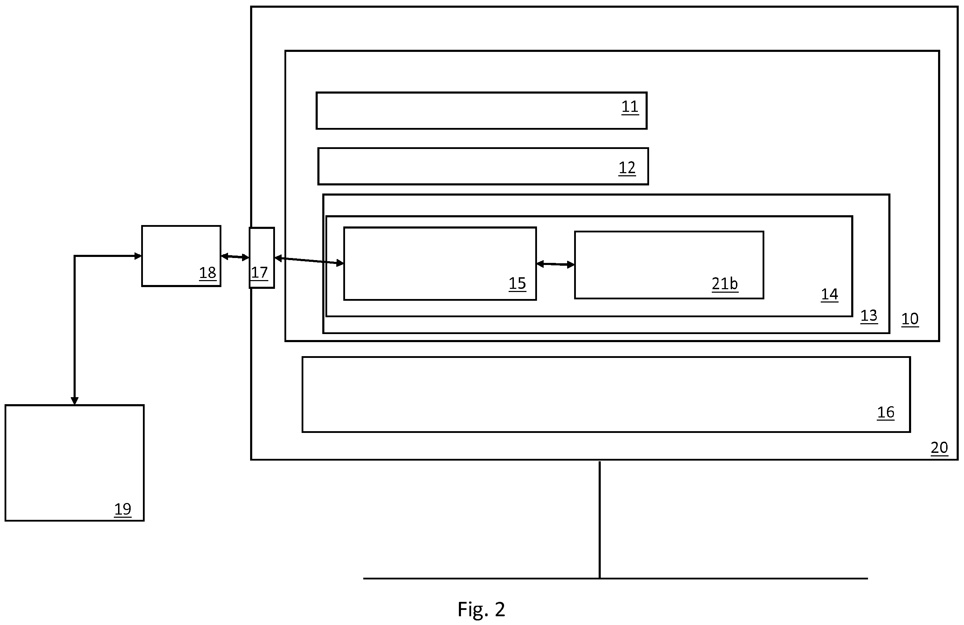

In Figur 2 ist dagegen ein weiteres Ausführungsbeispiel eine virtuellen Steuergeräts 10 gezeigt, in dem die Simulationsfunktion 21b sich in der Mikrocontroller-Abstraktions-Schicht 14 befindet und somit durch die Ausführung des virtuellen Steuergeräts 10 auf der Simulationsplattform 16 ausgeführt wird. In diesem Beispiel von Figur 2 erfolgt die Kommunikation von Softwarekomponente 15 und Simulationsfunktion 21b nicht über die Simulationsplattform 16, sondern direkt über entsprechende Softwareschnittstellen.

Ein weiteres, nicht in einer Figur dargestelltes Ausführungsbeispiel für die Simulationsfunktion 21 ist ein direkter Eingriff in die SPI-Kommunikation, wodurch der simulierte Signalwert entsprechend eines vom Benutzer fest vorgegebenen Werts überschrieben wird.

In beiden Ausführungsbeispielen von Figur 1 und Figur 2 wird gezeigt, dass die Softwarekomponente 15 über die USB-Schnittstelle 17 des PCs 20 mit einem USB-SPI-Adapter 18 verbunden ist. Dieser USB-SPI-Adapter 18 kann die Daten, die über SPI in den Adapter 18 vom externen Peripheriegerät 19 kommen in USB-kompatible Daten wandeln und umgekehrt die Daten vom virtuellen Steuergerät 10 auf einen SPI-Bus legen und zum externen Peripheriegerät 19 senden.

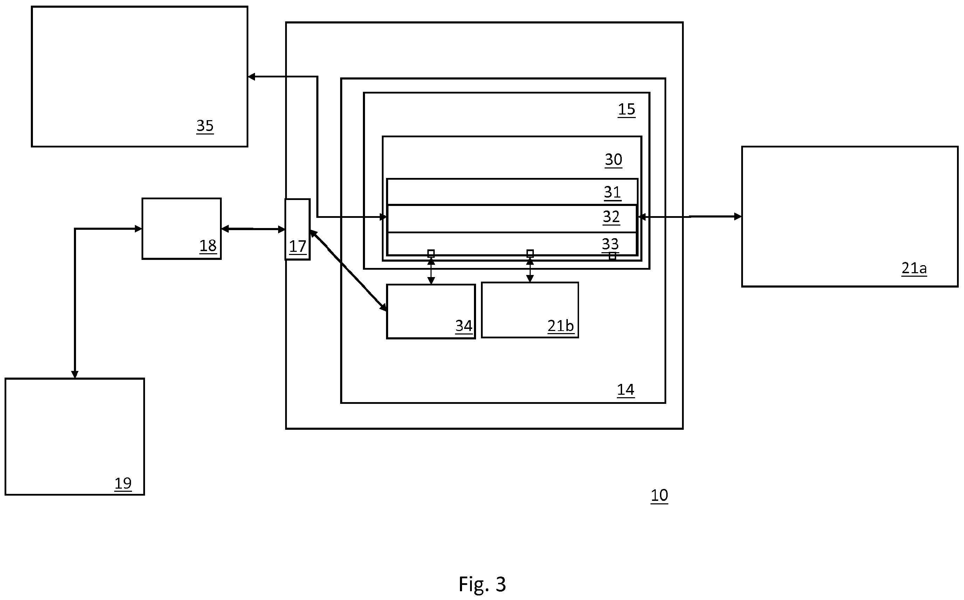

Ein detailliertes Anwendungsbeispiel für die Softwarekomponente 15 und ihre Funktionen ist in Figur 3 dargestellt. Die Softwarekomponente 15 enthält in diesem Beispiel einen SPI-Treiber 30. Der SPI-Treiber 30 enthält eine SPI-Treiber-Schnittstelle 31, eine Zugriffsmöglichkeit 32 auf die SPI-Kommunikation und eine SPI-GeräteSchnittstelle 33. Die SPI-Treiber-Schnittstelle 31 ist eine AUTOSAR-konforme Schnittstelle. Die Zugriffsmöglichkeit 32 wird über eine Benutzerschnittstelle 35 konfiguriert. Eine derartige Konfiguration kann mittels bekannter Konfigurierungsmöglichkeiten, wie z.B. textuell oder grafisch, erfolgen.

Über die Benutzerschnittstelle 35 wird die spezifische Zugriffsmöglichkeit 32 konfiguriert, indem ein Eingriffspunkt definiert wird, mit dem zur Simulationszeit die SPI-Kommunikation beeinflusst werden kann. Über diesen Eingriffspunkt wird festgelegt welcher Inhalt der SPI-Nachricht verändert werden soll und woher der veränderte Inhalt kommen soll.

Hierdurch können z.B. erwartete SPI-Nachrichten, die von einem Benutzer festgelegt wurden, direkt in die Simulation eingebracht werden, ohne dass ein SPI Peripheriegerät 19 oder eine Simulationsfunktion 21 an den SPI Bus angeschlossen ist. Ein Beispiel hierfür ist ein Kommunikationsaufbau zwischen externem Peripheriegerät 19 und virtuellem Steuergerät 20. Selbst wenn das externe Peripheriegerät 19 nicht vorliegt, können die für den Kommunikationsaufbau vom Peripheriegerät benötigten SPI-Nachrichten vorab gebildet werden und über die Konfiguration der spezifischen Zugriffsmöglichkeit 32 dem virtuellen Steuergerät 10 zur Verfügung gestellt werden.

Reichen Eingriffe in die SPI-Kommunikation für die Simulation nicht aus, dann kann ein externes Peripheriegerät 19 in Form einer Simulationsfunktion 21 nachgebildet werden. Beispielsweise kann die Softwarefunktion 21 als Simulationsfunktion 21a in das virtuelle Steuergerät 10 integriert werden. In einer bevorzugten Ausführungsform bietet die Softwarekomponente 15 hierfür eine entsprechende Schnittstelle 33 an.

Alternativ kann die Simulationsfunktion 21a außerhalb des virtuellen Steuergeräts 10 in einem Umgebungsmodell 22 ausgeführt werden.

Ein großer Nachteil bei einer solchen Emulation des externen Peripheriegeräts 19 ist der mitunter sehr hohe Implementierungsaufwand. Darüber hinaus wird für die Implementierung eine detaillierte Beschreibung der realen Hardware benötigt, welche nicht in jedem Fall zur Verfügung steht. Eine Softwareemulation bietet sich immer dann an, wenn das externe Peripheriegerät 19 vom Aufbau her eher einfach ist oder aber ein vereinfachtes Verhalten für die Simulation ausreichend ist.

Die Einbindung eines realen externen SPI Peripheriegeräts 19 bietet sich immer dann an, wenn für die Simulation ein exaktes Verhalten des externen Peripheriegeräts 19 benötigt wird und entsprechende Hardware zur Verfügung steht. Für diesen Fall zeigt das Ausführungsbeispiel in Figur 3 in der Mikrocontroller-Abstraktions-Schicht 14 einen entsprechenden USB/SPI-Treiber 34 welcher in Verbindung mit einem an den PC 20 angeschlossenen USB/SPI- Adapter 18 den Zugriff auf einen realen SPI Bus des externen Peripheriegeräts 19 ermöglicht.

Auch Mischformen sind möglich. So können manche Werte aus dem externen Peripheriegerät 19 kommen und andere aus der Simulationsfunktion 21.

Wenn z.B. Beschleunigungswerte aus dem externen Peripheriegerät 19 im virtuellen Steuergerät 10 eingelesen werden, aber eigentlich die Werte der Simulationsfunktion 21 genutzt werden sollen, dann müssen die Werte des realen externen Peripheriegeräts 19 durch die simulierten Werte überschrieben werden, wofür die zuvor schon beschriebene Zugriffsmöglichkeit 32 in die SPI Kommunikation verwendet wird.

Die SPI-Kommunikation wird beispielsweise, entsprechend der AUTOSAR-Spezifikation eines AUTOSAR SPI MCAL Moduls für die Anbindung von externem Speicher mittels sogenannter Sequences, Jobs und Channels definiert. Dabei kann eine Sequence aus mehrere Jobs bestehen und ein Job aus mehreren Channels. Beispielsweise umfasst eine Schreib-Sequence einen ersten Job und einen zweiten Job, von denen der erste Job einem Channel zugeordnet ist, der einen Speicherbaustein in den Schreibmodus schaltet. Der zweite Job besteht beispielsweise aus zwei Channels, einem ersten Channel, der die Adresse überträgt, an welche die Daten geschrieben werden sollen und einem zweiten Channel, der die zu speichernden Daten überträgt. Ähnlich aufgebaut könnten Sequences für einen Lesezugriff sein.

Für die Ausführung von SPI-Sequences bietet der SPI-Treiber 30 entsprechende Funktionen an. Wird eine Schreib-Sequence über die Geräteschnittstelle 33 gestartet, dann führt die Softwarekomponente 15 die zugehörigen Funktionen aus und überträgt die mit den Jobs verknüpften Channels. Ein Channel ist aus Applikationssicht ein Speicher, welcher vor dem Starten einer Sequence beschrieben und nach der Ausführung gelesen werden kann. Die Channels beschreiben letztendlich die Daten, die zwischen dem Microcontroller und einem externen SPI Peripheriegerät übertragen werden.

Ähnliche sehen Sequences aus, um z.B. die aktuellen Werte eines Beschleunigungssensors auszulesen. Die einzelnen Werte werden hier von dem externen Peripheriegerät 19 (Sensor) in Form von Registerinhalten bereitgestellt.

Die Register beinhalten bei einem Beschleunigungssensor beispielsweise die aktuellen Beschleunigungswerte der X, Y, und Z-Achse. So gibt es dann beispielsweise eine Lese-Sequence mit zwei Jobs. Ein Job beinhaltet einen Channel mit der zu lesende Registeradresse im Sensor. Ein weiterer Job umfasst drei Channel mit jeweils 16 Bits, jeweils ein Channel für die Beschleunigungswerte in X-Achse, Y-Achse und Z-Achse.

Um Werte während einer Simulation von einer Simulationsfunktion 21 zu verwenden, wurde das AUTOSAR SPI MCAL Modul erfindungsgemäß weiterentwickelt und beinhaltet nun eine Möglichkeit für den Benutzer in die Kommunikation zwischen virtuellem Steuergerät 10 und dem externen Peripheriegerät 19 einzugreifen. Dazu enthält die Softwarekomponente 15 beispielsweise eine oder mehrere SPI Zugriffsmöglichkeiten 32 auf die SPI-Kommunikation. Eine SPI-Zugriffsmöglichkeit bezieht sich dabei auf die Daten eines SPI Channels, welche im Rahmen einer SPI Sequence bzw. SPI Job Abarbeitung manipuliert werden können. Für die Konfiguration der Zugriffsmöglichkeit 32 muss daher die SPI Sequence, der SPI Job und der SPI-Channel sowie die Richtung, also Eingangs- bzw. Ausgangskommunikation angegeben werden.

Auf Basis der Konfiguration wird dann eine Implementierung für den SPI-Treiber 30 erzeugt, wobei Schnittstellen zur Verfügung gestellt werden, an denen die Werte der SPI Busmanipulation durch Anschluss an eine Simulationsfunktion 21, z.B. eine Simulationsfunktion 21a in einem Umgebungsmodell abgegriffen bzw. angelegt werden können.

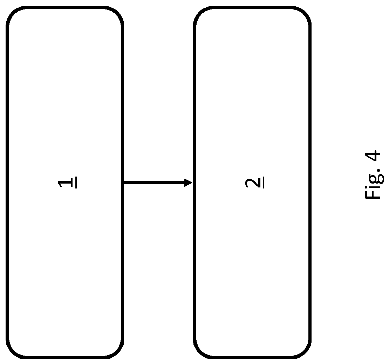

Figur 4 zeigt in einem Beispiel das erfindungsgemäße Verfahren. So konfiguriert ein Benutzer über die Benutzerschnittstelle 35 in einem Verfahrensschritt 1 eine Zugriffsmöglichkeit 32 und gibt darüber an, ob ein externer Signalwert aus einem externen Peripheriegerät 19 genutzt werden soll oder ob ein simulierter Signalwert aus einer Simulationsfunktion 21 genutzt werden soll.

In einem weiteren Verfahrensschritt 2 wird bei der Ausführung des virtuellen Steuergeräts 10 entsprechend der in Verfahrensschritt 1 ausgewählten Konfiguration der externe Signalwert des externen Peripheriegeräts 19 oder der simulierte Signalwert der Simulationsfunktion 21 genutzt als Signalwert des Eingabesignals genutzt.

## Patentansprüche

1. Computerimplementiertes Verfahren zur Einbindung mindestens eines Signalwerts in ein virtuelles Steuergerät (10),
wobei das virtuelle Steuergerät (10) eine Anwendungsschicht (11), eine Laufzeitumgebung (RTE) (12), eine Basissoftware-Schicht (13) und eine Mikrocontroller-Abstraktions-Schicht (14) aufweist,
wobei das virtuelle Steuergerät (10) auf einer Simulationsplattform mittels eines Personal Computers (20) ausgeführt wird,
wobei das virtuelle Steuergerät (10) mindestens ein Eingabesignal benötigt,
wobei dem Eingabesignal mindestens ein Signalwert zugeordnet werden kann,
wobei von einer Simulationsfunktion (21) mindestens ein erster simulierter Signalwert dem virtuellen Steuergerät (10) bereitgestellt wird,
**dadurch gekennzeichnet, dass**
die Mikrocontroller-Abstraktions-Schicht (14) eine Softwarekomponente (15) zur Einbindung des ersten simulierten Signalwerts und eines zweiten externen Signalwerts in einem virtuellen Steuergerät (10) aufweist,
wobei der zweite externe Signalwert von einem externen Peripheriegerät (19) bereitgestellt wird,
wobei ein Benutzer über eine Benutzerschnittstelle für das Eingabesignal eine Auswahl trifft, ob die Softwarekomponente (15) den ersten simulierten Signalwert oder den zweiten externen Signalwert nutzen soll,
wobei in einem weiteren Verfahrensschritt, bei der Ausführung des virtuellen Steuergeräts (10) entsprechend der Auswahl des Benutzers entweder der erste simulierte Signalwert oder der zweite externe Signalwert dem virtuellen Steuergerät (10) als Signalwert des Eingabesignals zur Verfügung gestellt wird.

2. Computerimplementiertes Verfahren nach Anspruch 2, **dadurch gekennzeichnet, dass** das
virtuelle Steuergerät (10) eine Nachricht an das externe Peripheriegerät (19) sendet und das externe Peripheriegerät (19) den zweiten externen Signalwert als Antwort auf die Nachricht bereitstellt.

3. Computerimplementiertes Verfahren nach Anspruch 1 oder Anspruch 2, **dadurch gekennzeichnet, dass** das externe Peripheriegerät (19) über einen USB-SPI-Adapter (18) an den Personal Computer (20) angeschlossen ist.

4. Virtuelles Steuergerät (10),
wobei das virtuelle Steuergerät (10) eine Anwendungsschicht (11), eine Laufzeitumgebung (RTE) (12), eine Basissoftware-Schicht (13) und eine Mikrocontroller-Abstraktions-Schicht (14) aufweist,
wobei das virtuelle Steuergerät (10) auf einer Simulationsplattform (16) mit einem Personal Computer (20) ausführbar ist,
wobei das virtuelle Steuergerät (10) mindestens ein Eingabesignal benötigt,
wobei dem Eingabesignal mindestens ein Signalwert zugeordnet werden kann,
wobei das virtuelle Steuergerät (10) mindestens eine Simulationsschnittstelle aufweist, um einen ersten simulierten Signalwert von einer Simulationsfunktion (21) zu erhalten,
**dadurch gekennzeichnet, dass**
das virtuelle Steuergerät (10) mindestens eine Peripheriegeräteschnittstelle (17) aufweist,
wobei über die Peripheriegeräteschnittstelle (17) mindestens ein zweiter externer Signalwert an das virtuelle Steuergerät (10) übertragen werden kann,
wobei der zweite externe Signalwert von mindestens einem externen Peripheriegerät (19) bereitgestellt wird,
die Mikrocontroller-Abstraktions-Schicht (14) eine Softwarekomponente (15) zur Einbindung des ersten simulierten Signalwerts und des zweiten externen Signalwerts in das virtuelle Steuergerät (10) aufweist,
das virtuelle Steuergerät (10) eine Benutzerschnittstelle zum Benutzer aufweist, durch die der Benutzer für das Eingabesignal entscheiden kann, ob die Softwarekomponente (15) den ersten simulierten Signalwert oder den zweiten externen Signalwert als Signalwert für das Eingabesignal nutzen soll.

5. Virtuelles Steuergerät (10) nach Anspruch 4, **dadurch gekennzeichnet, dass** das externe Peripheriegerät (19) über einen USB-SPI-Adapter (18) an den Personal Computer (20) angeschlossen ist.

6. Virtuelles Steuergerät (10) nach Anspruch 4 oder Anspruch 5, **dadurch gekennzeichnet, dass** die Softwarekomponente (15) derart ausgestaltet ist, dass mittels der Softwarekomponente (15) Nachrichten an das externe Peripheriegerät (19) gesendet werden können.
